# EUROPEAN PATENT APPLICATION

(11) **EP 0 984 030 A2**
(43) Date of publication of application: **08.03.2000**
(21) Application number: 99306835.2
(22) Date of filing: 27.08.1999
(51) Int. Cl.: C08J 5/18

(54) **Polyimide film and process for manufacture thereof**

(30) Priority: 31.08.1998 JP 26232398
(71) Applicant: DU PONT-TORAY COMPANY, LTD., Chuo-ku, Tokyo 103-0023 (JP)
(72) Inventor: Okahashi, Masakazu, Nagoya, 458-0044 (JP); Nishiya, Yoshitaka, Ikenowaki Ohbu 474-0031 (JP); Teramoto, Shigehiro, Chita, 478-0014 (JP)
(74) Representative: Woodman, Derek

(57) **Abstract**

The polyimide film of this invention is prepared by continuously extruding or coating a polyamic acid solution onto a rotating support to form a web having a thickness irregularity in the lengthwise direction in terms of a 5-point average of not more than 0.9 µm and a maximum local thickness irregularity value of not more than 1.0 µm. The process of this invention for the manufacture of a polyimide film comprises the step of casting, by continuously extruding or coating, a polyamic acid solution in web form onto a rotating support. The web has a casting rotation forward-moving direction side and an opposite or trailing direction side. A difference between the web pressure on the casting rotation direction side and that on the opposite side of the web of greater than 10 Pa, but not more than 750 Pa is maintained.

## Description

### BACKGROUND OF THE INVENTION

The present invention relates to a polyimide film with improvements in the thickness irregularities in the lengthwise direction and a process for the manufacture thereof. The invention further relates to a polyimide film having reduced thickness irregularities that is suitable for use as a support for an electrical circuit board having a metal foil, typically copper foil, or metal thin film laminated thereto, and as an overlay film for protecting flexible printed circuits.

Polyimide films, because of their high heat resistance and high electrical insulation properties, are used in broad industrial application areas as electrical insulation materials where heat resistance is required.

Polyimide films are useful as supports for electrical circuit boards and have copper foils laminated to them. In an application wherein the polyimide film enables solder-connecting electrical parts such as IC's, and the like, to copper foil, electrical circuits that are smaller in size and lighter in weight are obtained.

However, with the proliferation in the types of applications for electrical circuit boards, along with the advances in higher densities in terms of the number of wires, there has been an increase in demand for improvements in the performance properties of polyimide films for their use as electrical insulation supports and for improved processibility.

Polyimide film has been manufactured heretofore by casting a polyamic acid solution from a die onto a casting drum or belt or like support. The film then undergoes a chemical or thermal cyclization process and/or drying so as to solidify it to the extent of being self-supporting. The web form resin is then peeled off from the casting drum or endless belt, followed by heating, stretching, and heat treating it in a tenter.

However, the above manufacturing process has been deficient in that the amic acid solution, when extruded in a web form from the die, has tended to vibrate, due to air or machine vibrations and the like, before the solution contacts the support, creating thickness irregularities.

Polyimide films with such thickness irregularities, if used in electronic parts such as heat resistant, flexible printed circuits (FPC), will cause coating irregularities when a heat resistant adhesive is applied to the polyimide film. Lamination irregularities are formed when the polyimide is laminated to copper foil. This results in adversely effecting the electrical properties of the circuit when completed.

Attempts have been made to use polyester films with improvements in thickness irregularities for flexible printed circuits, but their poor soldering heat resistance has resulted in deficiencies so that it has been not possible to make electrical circuits smaller in size and lighter in weight.

### SUMMARY OF THE INVENTION

It is an object of this invention to provide a polyimide film with reduced thickness irregularities in the lengthwise direction that are suitable for use as a support for electrical circuit boards to which metal foil, typically copper foil or a metal thin film, is laminated. These films are also useful as overlay films for protecting flexible printed circuits.

This invention provides a process for the manufacture of a polyimide film prepared by continuously extruding or coating, a polyamic acid solution onto a rotating support having a casting rotation direction, to form a web having a casting rotation direction side and a trailing direction side, wherein the difference between the web pressure (P1) on the casting rotation direction side and the web pressure (P2) on the trailing direction side of the web is greater than 10 Pa.

In another embodiment, the invention provides polyimide film prepared by continuously extruding or coating, a polyamic acid solution onto a rotating support having a casting rotation direction, to form a web having a casting rotation direction side and a trailing direction side, wherein a local thickness irregularity in the lengthwise direction in terms of a 5-point average is not more than 0.9 µm and a maximum local thickness irregularity value is not more than 1.0µm, as explained hereinafter.

The present invention improves thickness irregularities in the lengthwise direction, and in particular, makes it possible to obtain a polyimide film suitable for use as a support for electrical circuit boards to which a metal foil, typically copper foil, or thin metal film may be laminated. This film may also be used as an overlay film for protecting flexible printed circuits (FPC). The polyimide film also has good FPC processability and provides a circuit with stable electrical properties.

### BRIEF DESCRIPTION OF THE DRAWINGS

Figure 1 is a schematic illustration of an apparatus using a pressurization device useful in the implementation of the invention.

Figure 2 is a schematic illustration of an apparatus using an evacuation device useful in the implementation of the invention.

Figures 3 and 3a are two different views of the pressurization device useful in this invention.

Figures 4 and 4a are two different views of the evacuation device useful in this invention.

Figure 5 is a representation of web pressure (P1) on the casting rotation direction side and the web pressure (P2) on the trailing direction side.

### DETAILED DESCRIPTION OF THE INVENTION

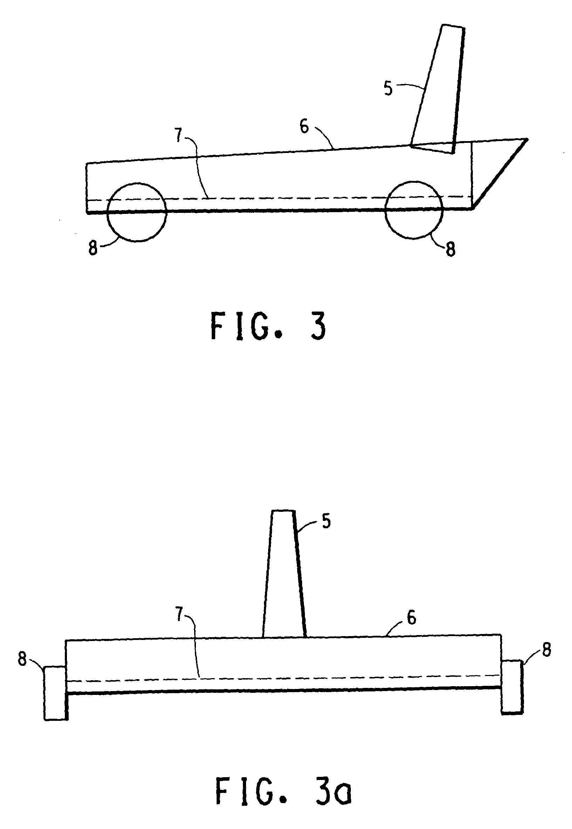

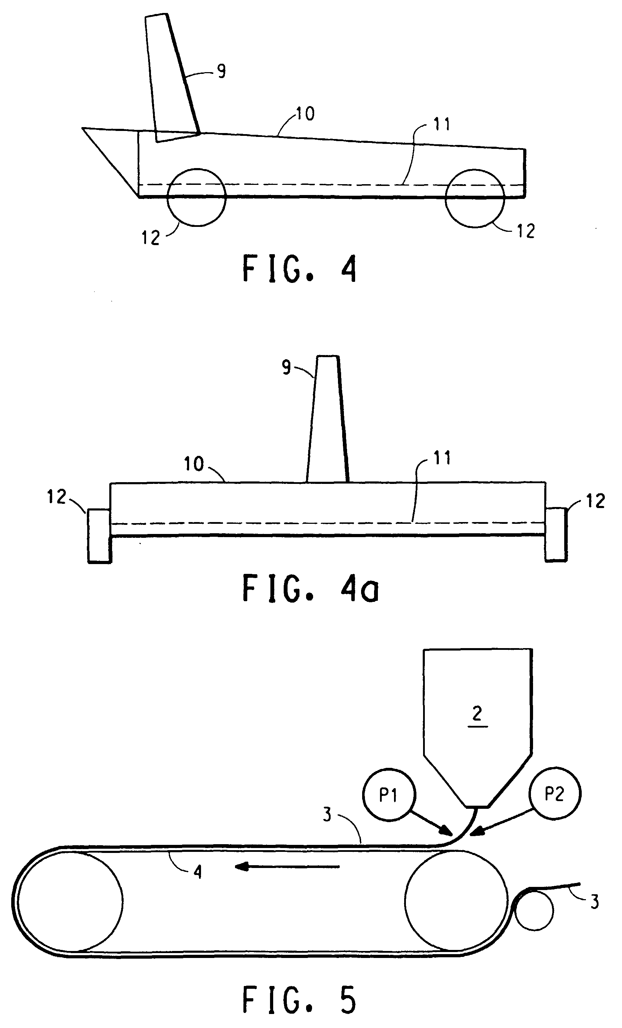

In the process of this invention, for the manufacture of a polyimide web 2, in order to achieve a difference between the web pressure on the casting rotation direction side and that on the opposite side, which is the trailing direction side of the web, of greater than 10 Pa, but not more than 750 Pa, a gas pressurization device, as shown in detail in Figures 3 and 3a, may be used on the casting rotation direction side, thereby pressuring the web on its forward-moving direction side. Alternately, an evacuation device, as shown in detail in Figures 4 and 4a, is mounted on the side opposite to said casting rotation direction, i.e. the trailing direction side, thereby bringing the web trailing direction side to be at reduced pressure. This results in the gas flow velocity on either the gas pressurization device side or the evacuation device side being controlled to 5 m/sec or less.

The polyimide film of the present invention has substantial improvements in thickness irregularity compared to the conventional polyimide film in that the thickness irregularity in the lengthwise direction in terms of a 5-point average is not more than 0.9 µm and the maximum local thickness irregularity value is not more than 1.0 µm.

The process for the manufacture of polyimide film of this invention enables one to manufacture polyimide films stably and inexpensively with improvements in thickness irregularities in the lengthwise direction.

The polyamic acid, which is a precursor of the polyimide of this invention, comprises the reaction product of an aromatic tetracarboxylic acid and an aromatic diamine and is made up of the repeating units given by the following formula: 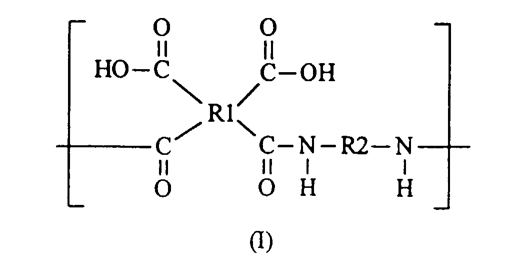 where R1 in the above formula is a tetravalent organic group which has at least 1 aromatic ring, and has not more than 25 carbon atoms; each of the 2 carboxyl groups connected to R1 is connected to a carbon atom adjacent to the carbon atom connected to the amide group of the aromatic ring in R1;R2 is a divalent organic group which contains at least 1 aromatic ring and which has not more than 25 carbon atoms; the amino group is connected to the carbon atom of the aromatic ring in R2.

The above aromatic tetracarboxylic acids are specifically, for example, pyromellitic acid, 3,3,4,4'-biphenyl tetracarboxylic acid, 2,3',3,4'-biphenyl tetracarboxylic acid, 3,3'4,4'-benzophenone tetracarboxylic acid, 2,3,6,7-naphthalene dicarboxylic acid, 2,2-bis(3,4-dicarboxy phenyl) ether, pyridine-2,3,5,6-tetracarboxylic acid and their amic-forming derivatives and the like. The acid anhydrides are preferably used in the manufacture of the polyamic acid.

The above aromatic diamines are specifically paraphenylene diamine, metaphenylene diamine, benzidine, paraxylylene diamine, 4,4'-diamino diphenyl ether, 4,4'-diamino diphenyl methane, 4,4'-diamino diphenyl sulfone, 3,3'-dimethyl-4,4'-diamino dimethyl methane, 1,5-diamino naphthalene, 3,3'-dimethoxy benzidine, 1,4-bis(3-methyl-5-amino phenyl) benzene and their amide forming derivatives and the like.

The organic solvents which are used to generate the polyamic acid solutions in this invention specifically include, for example, organic polar amide solvents such as N,N-dimethyl formamide, N,N-dimethyl acetamide, N-methyl-2-pyrrolidone, and the like. These organic solvents may be used alone or in combinations of 2 or more, or else in combinations with non-solvents such as benzene, toluene, and xylylene.

The polyamic acid solution in organic solvents used in this invention should have 5-40% by weight, preferably 10-30% by weight of solids and have a viscosity of 100-20,000 poise, preferably 1,000-10,000 poise as measured by a Brookfield viscometer in that such a range enables a liquid transport.

The polyamic acid solution in the organic solvent may be partially imidized or may contain small amounts of inorganic compounds.

In this invention, the aromatic tetracarboxylic acid and the aromatic diamine are polymerized on an equimolar basis or in an amount in which one of the two may be formulated in excess with respect to the other within 10 mole %, preferably within 5 mole %.

The polymerization reaction is carried out while the mixture is stirred and/or mixed in an organic solvent over the temperature range of 0-80°C continuously for 10 minutes to 30 hours. Optionally, the polymerization reaction may be conducted in two or more steps or the temperature may be raised or lowered.

In the above case, there is no particular limitation as to the sequence of adding the two reactants, but preferably the aromatic tetracarboxylic acid is added to the solution of the aromatic diamine.

Vacuum defoaming in the polymerization reaction is an effective method for the production of a high quality polyamic acid solution in an organic solvent. A small amount of an end-group terminator may be added to the aromatic diamine prior to the polymerization reaction so as to regulate the polymerization reaction.

Cyclization catalysts which are used in this invention specitically include, for example, aliphatic tertiary amines such as trimethyl amine, triethylene diamine and the like, heterocyclic tertiary amines such as isoquinoline, pyridine, betapicoline, and the like, preferably at least one amine selected from the heterocyclic tertiary amines.

The dehydration agents which are used in this invention specifically, for example, include aliphatic carboxylic anhydrides such as acetic anhydride, propionic anhydride butyric anhydride and the like, and aromatic carboxylic anhydrides such as benzoic anhydride, preferably acetic anhydride and/or benzoic anhydride.

The number of moles of the cyclization catalyst/number of moles of polyamic acid is 0.5-8.

The number of moles of the dehydrating agent/number of moles of polyamic acid is 0.1-4.

One may also use in combination a gelation retarder such as acetyl acetone and the like.

Typical methods for the production of a polyimide film from a polyamic acid in an organic solvent include a thermal cyclization process which calls for casting the solution of a polyamic acid containing no cyclization catalyst or dehydration agent, in an organic solvent, from a slit die to a support for web formation, followed by heating and drying on the support, thereby generating a self-supporting gel web, peeling off the web from the support, and drying and heat treating further at high temperatures. Another method includes a chemical cyclization process which calls for casting the the polyamic acid in an organic solvent containing a cyclization catalyst and a dehydration agent from a slit die onto a support to generate a web form, allowing a partial imidization to proceed on the support to generate a self-supporting gel web, peeling the web from the support, then heating and drying-imidizing, thereby heat treating said web.

Either of the above cyclization methods can be used in this invention, but the chemical cyclization process is a preferred method in that a self-supporting gel web can be obtained in short time, although the process requires an installation to incorporate the cyclization catalyst and dehydration agent in the solution of the polyamic acid in the organic solvent.

It is an essential requirement in the process for the manufacture of the polyimide film of this invention that in the casting stage of the process wherein the a polyamic acid solution is continuously extruded or coated in web form onto a rotating support, that the difference between the web pressure on the casting rotation direction side and that on the opposite side of the web should be greater than 10 Pa, but not more than 750 Pa, preferably no more than 650 Pa, thereby making it possible to produce a polyimide film with improvements in thickness irregularities in the lengthwise direction.

### Process Of Manufacture:

The casting stage in the process of manufacturing the polyimide film of this invention is explained with reference to the drawings.

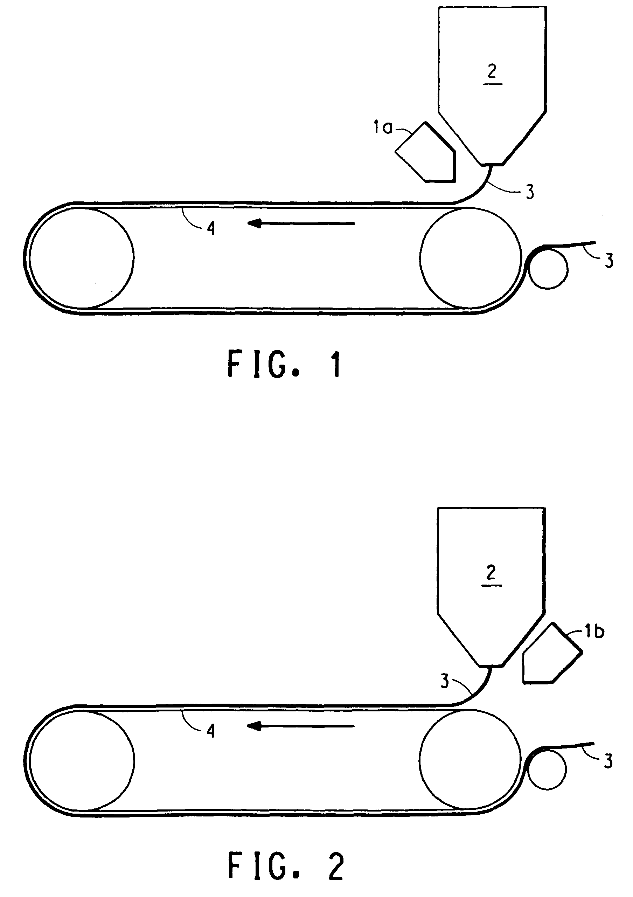

In Figure 1, 2 is a slit die; 3 is a polyamic acid solution web extruded from the die; 4 is an endless belt (support) held over a pair of rollers, moving forward in direction shown by the arrow.

A gas pressurization device 1a, shown in detail in Figures 3 and 3a, is mounted in the web forward-moving or casting rotation direction side to provide a difference, between the web pressure on the casting rotation direction side (P1) and that on the opposite side, i.e., the trailing direction side of the web (P2), as shown in Figure 5, of greater than 10 Pa, but not more than 750 Pa. Referring now to Figure 2, an evacuation device 1b, shown in detail in Figures 4 and 4a, may alternatively be used to provide a difference between the web pressure on the casting rotation direction side (P1) and that on the trailing direction side of the web (P2), as shown in Figure 5, of greater than 10 Pa, but not more than 750 Pa. The pressurization and evacuation devices may be used in combination as long as the specified difference in web pressure is maintained.

The gas pressurization device 1a is mounted so as to provide a gap distance between support 4 and polyamic acid solution web 3 that is as narrow as possible so as not to cause any turbulence to the pressurizing gas, thereby pressing down the web on its forward moving or casting rotation direction side.

The pressurization device 1a is shown in more detail in Figures 3 and 3a. It comprises an air chamber 6, equipped with a screen 7 and an air supply nozzle 5. Supports 8 are provided to aid in positioning the air chamber 6.

The gas flow rate by the gas pressurization device 1a is preferably controlled to be not higher than 5 m/sec. If the gas flow rate exceeds 5 m/sec, the polyamic acid solution web 3 will vibrate due to the effect of the gas flow resulting in the generation of thickness irregularities.

The gas should be at temperatures of 0°C-200°C, preferably to 40°C-150°C.

Raising the pressure on the forward-moving or casting rotation direction side of the polyamic acid solution web 3 being extruded from the die 2 by at least 10 Pa, but no more than 750 Pa, preferably by at least 20 Pa, but not more than 650 Pa, over the pressure on the trailing direction side by the gas pressurization device 1a mounted on the web casting rotation direction side can make improvements on thickness irregularities in the lengthwise direction, enabling the production of a polyimide film having local thickness irregularities in the lengthwise direction in terms of a 5 point average of not more than 0.9 µm and a maximum local thickness irregularity value of not more than 1.0 µm.

A pressure in the forward moving direction side or casting rotation direction side of the polyamic acid solution web 3 less than 10 Pa higher than the pressure on the trailing direction side will have too low a pressure to stabilize the polyamic acid solution web, worsening performance in terms of web thickness. A pressure difference of 750 Pa or higher will further stabilize in terms of thickness, but the pressure will be too high, at times breaking the polyamic acid web.

As shown in Figures 1, 2 and 5, the polyamic acid solution 3 cast as a web on a support 4 such as an endless belt will be uniformly heated and imidized or cyclized and dried to give a self-supporting gel web.

The gel web is then peeled off from the support 4 such as an endless belt, followed by stretching, drying, heat treating, cooling, and being wound up into a roll as a product.

The device shown in Figure 2, an evacuation device 1b is mounted on the trailing direction side of the web in order to provide a difference between the web pressure on the casting rotation direction side and the trailing direction side of greater than 10 Pa, but not more than 750 Pa.

This evacuation device lb is also mounted so that the gap distance between the support 4 and the polyamic acid solution web 3 is as narrow as possible so as not to disturb the ambient pressurizing gas, thereby reducing the pressure on the trailing direction of the web.

The evacuation device is also shown in more detail in Figures 4 and 4a. It comprises an air chamber 10, equipped with a screen 11, and an air exhaust nozzle 9. Supports 12 are provided to aid in positioning the air chamber 10.

The gas flow velocity by the evacuation device 1b should preferably be controlled to be not higher than 5 m/sec. A gas flow velocity exceeding 5 m/sec will result in the polyamic acid solution web 3 vibrating due to the effects of the gas flow, causing thickness irregularities.

The gas should be at temperatures of 0°C-200°C, preferably to 40°C to 150°C.

Providing a difference between the web pressure on the forward-moving or casting rotation direction side of the polyamic acid solution web 3 being extruded from the die 2 and the opposite side of the web, i.e., the trailing direction side of the web, of greater than 10 Pa, but no more than 750 Pa, preferably at least by 20 Pa, by the evacuation device 1b mounted on the web trailing direction side can make improvements on thickness irregularities in the lengthwise direction, enabling the production of a polyimide web having thickness irregularities in the lengthwise direction in terms of a 5 point average of not more than 0.9 µm and a maximum local thickness irregularity value of not more than 1.0 µm.

Those skilled in the art will appreciate that the devices which may be used for carrying out the process of this invention are not limited to those given in Figures 1-5.

### EXAMPLES

The present invention is further explained by the following examples of this invention, but the invention is not necessarily limited to these examples.

### Procedure for Measuring Local Thickness Irregularities in the Lengthwise Direction:

The web was moved forward at the rate of 1.5 m/min by a web feeder while using a broad range electronic micrometer K301, manufactured by Anritsu Company, thereby recording the thickness as a thickness chart using a table top automatic balance recorder made by Nippon Denshi Kagaku KK. A web 1500 mm long and 50 mm in width was cut out in the lengthwise direction as a sample. Then the height between the neighboring peaks and troughs was read and the sum of the differences between each peak and trough was represented as Rn; the maximum local thickness irregularity as (R1) and the 5 point average of the thickness irregularities from the maximum to the 5^{th} values as (R5a).

### EXAMPLE 1

20.0024 kg (0.1 kmol) of 4,4'-diamino diphenyl ether were dissolved in 190.6 kg of dried N,N-dimethyl acetamide and the mixture was stirred at 20°C to which 21.812 kg (0.1 kmol) of purified powdery pyromellitic dianhydride were added in small portions and the mixture was stirred continuously for 1 hour to obtain a clear polyamic acid solution. The solution had a viscosity of 3500 poise at 20°C.

The polyamic acid solution was mixed with 2.5 moles of acetic anhydride based on the polyamic acid unit and 2.0 moles of pyridine with respect to the polyamic acid unit while the solution was cooled to obtain a polyamic acid solution in the organic solvent.

The polyamic acid organic solution was chilled to -10°C and metered in using a device shown in Figure 1 for web formation. The solution was extruded from a T die with the die slit width 1.3 mm and length 1800 mm.

Dry air at 2 m/sec was fed to the pressurization device to set the pressure on the forward-moving or casting rotation direction side of the polyamic acid solution web at 300 Pa.

The polyamic acid solution web was cast onto a metal endless belt at 90°C to obtain a self-supporting gel web. The gel web was peeled off the metal endless belt, stretched in the forward-moving direction at a temperature of 65°C, and then was moved to a tenter.

The web was stretched in the tenter in the transverse direction, followed by drying 40 seconds at a temperature of 260°C and then heat treating for 1 minute at 430°C, chilling under relaxation in a chilling zone for 30 seconds, and edge cutting the web to give a 2,000 mm wide and 25 µm thick biaxially stretched polyimide film.

This film had an R1 of 0.5 µm and an R5a of 0.4 µm.

The film was coated with a polyester/epoxy adhesive using a roll coater and dried in an oven at 160°C. Electrolytic copper foil was pressure-laminated to the adhesive coated face of the film at 130°C, followed by curing 24 hours to obtain a flexible copper clad polyimide sheet.

The resulting flexible copper clad polyimide sheet not only did not repel adhesive, but also gave a good appearance and good result with respect to dielectric property irregularities.

### EXAMPLE 2

Example 1 was repeated except for changing the die slit width to 1.3 mm and the length to 1500 mm long, thereby extruding the polyamic acid in organic solution from the T die.

Dry air at 1 m/sec was fed to the pressurization device to set the pressure on the forward-moving or casting rotation direction side of the polyamic acid solution web at 30 Pa.

In a manner similar to that of Example 1, a 1400 mm wide and 25 µm thick biaxially stretched polyimide film was obtained.

The film had an R1 of 0.4 µm and R5a of 0.3 µm.

The film was coated with a polyester/epoxy adhesive using a roll coater and dried in an oven at 160°C. Electrolytic copper foil was pressure-laminated to the adhesive coated face of the film at 130°C, followed by curing 24 hours to obtain a flexible copper clad polyimide sheet.

The resulting flexible copper clad polyimide sheet not only did not repel adhesive, but also gave a good appearance and good result with respect to dielectric property irregularities.

### EXAMPLE 3

Example 1 was repeated except for changing the die slit width to 1.8 mm and the length to 1800 mm long, thereby extruding the polyamic acid in organic solution from the T die.

Dry air at 3 m/sec was fed to the pressurization device to set the pressure on the forward-moving direction side of the polyamic acid solution web at 650 Pa.

In a manner similar to that of Example 1, a 2,100 mm wide and 12 µm thick biaxially stretched polyimide film was obtained.

The film had an R1 of 0.6 µm and R5a of 0.4 µm.

The film was coated with a polyester/epoxy adhesive using a roll coater and dried in an oven at 160°C. Electrolytic copper foil was pressure-laminated to the adhesive coated face of the tilm at 130°C, followed by curing for 24 hours to obtain a tlexible copper clad polyimide sheet.

The resulting flexible copper clad polyimide sheet not only did not repel adhesive. but also gave a good appearance and good result with respect to dielectric property irregularities.

### EXAMPLE 4

14.002 kg (0.07 kmol) of 4,4'-diamino diphenyl ether and 3.236 kg (0.03 kmol) of para-phenylenediamine were dissolved in 190.6 kg of dried N,N-dimethyl acetamide and the mixture was stirred at 20°C to which 21.812 kg (0.1 kmol) of purified powdery pyromellitic dianhydride were added in small portions and the mixture was stirred continuously for 1 hour to obtain a clear polyamic acid solution. The solution had a viscosity of 3500 poise at 20°C.

The polyamic acid solution was mixed with 2.5 moles of acetic anhydride based on the polyamic acid unit and 2.0 moles of pyridine with respect to the polyamic acid unit while the solution was cooled to obtain a polyamic acid solution in the organic solvent.

The polyamic acid organic solution was chilled to -10°C, and metered in, using the device shown in Figure 2 for film formation.

The solution was extruded from aT die with the die slit width 1.3 mm and length 1800 mm. The air was evacuated by the evacuation device from the polyamic acid solution web trailing direction at a rate of 1 m/sec to set the pressure difference between the forward-moving or casting rotation direction side and the trailing direction side of the polyamic acid solution web at 300 Pa.

The polyamic acid solution web was cast onto a metal endless belt at 120° to obtain a self-supporting web.

The gelled web was peeled off from the metal endless-belt and was led to the tenter while the web was stretched in the forward-moving direction at temperature of 65°C. The web was then stretched in the tenter in the transverse direction, dried for 40 seconds at a temperature of 260°C, then heat treated for 1 minute at 430°C, and chilled under relaxation in a chilling zone for 30 seconds, followed by edge cutting the web to give a 2,000 mm wide and 25 µm thick biaxially stretched polyimide film.

This film had an R1 of 0.5 µm and an R5a of 0.4 µm.

The film was coated with a polyester/epoxy adhesive using a roll coater and dried in an oven at 160°C. Electrolytic copper foil was pressure-laminated to the adhesive coated face of the tilm at 130°C, followed by curing 24 hours to obtain a flexible copper clad polyimide sheet.

The resulting flexible copper clad polyimide sheet not only did not repel adhesive, but also gave a good appearance and good result with respect to dielectric property irregularities.

### COMPARATIVE EXAMPLE 1

Example 3 was repeated in a similar manner to form films with the following exception: the pressurization device was not used to obtain a 2100 mm wide and 12 µm thick biaxially stretched polyimide film.

This film had an R1 of 1.5 µm and R5a of 0.9 µm.

The film was coated with a polyester/epoxy adhesive using a roll coater and dried in an oven at 160°C. Electrolytic copper foil was pressure-laminated to the adhesive coated face of the film at 130°C, followed by curing 24 hours to obtain a flexible copper clad polyimide sheet.

The resultant flexible copper clad polyimide sheet repelled the adhesive and gave a poor appearance due to the inclusion of gas bubbles.

### COMPARATIVE EXAMPLE 2

Example 3 was repeated with the following exception: dry air was fed at the rate of 6m/sec using the pressurization device and the difference in web pressure between the casting rotation side and the trailing side of the polyamic acid web was set at 800 Pa.

As a result, the polyamic acid organic solvent solution web broke, preventing film formation.

## Claims

1. A process for the manufacture of a polyimide film prepared by continuously extruding or coating, a polyamic acid solution onto a rotating support having a casting rotation direction, to form a web having a casting rotation direction side and a trailing direction side, wherein the difference between the web pressure on the casting rotation direction side (P1) and the web pressure on the trailing direction side (P2) of the web, is greater than 10Pa.

2. A process for the manufacture ofa polyimide film as in Claim I wherein the difference between the web pressure on the casting rotation direction side and the web pressure on the trailing direction side of the web is up to 750 Pa.

3. A process for the manufacture of a polyimide film as in Claim 1 or Claim 2 wherein the difference between the web pressure on the casting rotation direction side and the web pressure on the trailing direction side of the web is provided by a gas pressurization device mounted on the said casting rotation direction side, thereby pressuring the web on its casting rotation direction side.

4. A process for the manufacture of a polyimide film as in Claim 3 wherein the gas pressurization device has a gas flow velocity of 5 m/sec or less.

5. A process for the manufacture of a polyimide film as in Claim 1 or Claim 2 wherein the difference between the web pressure on the casting rotation direction side and the web pressure on the trailing direction side of the web is provided by an evacuation device mounted on the trailing direction side of the web, thereby bringing the web trailing direction side to be at reduced pressure.

6. A process for the manufacture of a polyimide film as in Claim 5 wherein the gas flow velocity on the side at which said evacuation device is mounted is controlled to 5 m/sec or less.

7. A laminate comprising a polyimide film prepared by the process of any one of Claims 1-6 and having: a thickness irregularity in the lengthwise direction in terms of a 5-point average of not more than 0.9 µm; a maximum local thickness irregularity value of not more than 1.0 µm; and said polyimide film having a metal layer on at least one side thereof.

8. A laminate in accordance with Claim 7 wherein the metal layer is a metal foil.

9. A laminate in accordance with Claim 8 wherein the metal foil is copper.

10. A polyimide film prepared in accordance with the process of any one of claims 1-6 having a thickness irregularity in the lengthwise direction in terms of a 5-point average of not more than 0.9 µm and a maximum local thickness irregularity value of not more than 1.0 µm.
